Europäisches Patentamt

European Patent Office

Office européen des brevets

(11) Veröffentlichungsnummer: **0 382 141**
**A1**

## (12) EUROPÄISCHE PATENTANMELDUNG

(21) Anmeldenummer: **90102219.4**

(22) Anmeldetag: **05.02.90**

(51) Int. Cl.⁵: **H05K 5/00**

(30) Priorität: **06.02.89 DE 3903488**

(43) Veröffentlichungstag der Anmeldung:
**16.08.90 Patentblatt 90/33**

(84) Benannte Vertragsstaaten:
**CH DE ES FR GB IT LI**

(71) Anmelder: **Schmitz, Elke**
**Prager Strasse 12**
**D-8264 Waldkraiburg(DE)**

(72) Erfinder: **Schmitz, Reiner**
**Prager Strasse 12**
**D-8264 Waldkraiburg(DE)**

(74) Vertreter: **Weber, Otto Ernst, Dipl.-Phys. et al**
**Weber & Heim Hofbrunnstrasse 36**
**D-8000 München 71(DE)**

(54) **Gehäuse.**

(57) Ein mechanisch stabiles Gehäuse, insbesondere für elektrische Geräte, ist kostengünstig herstellbar, wenn mindestens drei uniaxial ausgerichtete Seitenwände des Gehäuses durch im Strangpreßverfahren hergestellte Winkelprofile gebildet sind, die durch im Bereich ihrer freien Längskanten ausgebildete formschlüssige Rastverbindungen, vorzugsweise Nut- und/oder Federprofile miteinander verbunden sind, und wenn mindestens eine Stirnseite der miteinander verbundenen Winkelprofile von einer Stirnwand abdeckbar ist.

Fig. 1

EP 0 382 141 A1

## Gehäuse

Die Erfindung betrifft ein Gehäuse, insbesondere für elektronische Geräte.

Es sind Gehäuse dieser Art bekannt, die aus gebogenen und miteinander verschraubten Blechteilen bestehen. Für die Herstellung derartiger Gehäuse müssen Blechbiege- und Stanzmaschinen angeschafft werden, die neben hohen Investitionskosten auch hohe Wartungskosten und große Standflächen erfordern. Gebogene Blechteile sind darüber hinaus oftmals an ihren Knickstellen in ihrer mechanischen Stabilität beeinträchtigt.

Es ist **Aufgabe** der Erfindung, ein mechanisch stabiles Gehäuse zu schaffen, das auf einfache und kostengünstige Art herstellbar ist.

Die Aufgabe wird durch ein Gehäuse gelöst, bei dem mindestens drei uniaxial ausgerichtete Seitenwände durch im Strangpreßverfahren hergestellte Winkelprofile gebildet sind, die durch im Bereich ihrer freien Längskanten ausgebildete formschlüssige Rastverbindungen, vorzugsweise Nut- und/oder Federprofile, miteinander verbunden sind und bei dem mindestens eine Stirnseite der miteinander verbundenen Winkelprofile von einer Stirnwand abdeckbar ist. Als Winkelprofile können wannenförmige Profile mit mehreren Kanten, vorzugsweise L- oder U-förmige Profile verwendet werden, die Gehäuse mit unterschiedlich vielen uniaxial ausgerichteten Seitenwänden bilden, je nach Anzahl der Kanten der verwendeten Winkelprofile. Die Winkelprofile können auch als Profile mit einer kreissegmentförmigen oder runden Grundfläche ausgebildet sein, die dann zylinderförmige Gehäuse mit runder oder ovaler Grundfläche bilden. Zur Herstellung besonders breiter Gehäuse können eventuell auch plane Profile eingesetzt werden. Für die mechanische Stabilität ist die Verwendung von lediglich zwei Winkelprofilen für ein Gehäuse günstig, da hierbei an den Längskanten nur zwei Verbindungsstellen existieren, deren Anzahl bei einem mechanisch stabilen Gehäuse so gering wie möglich zu halten ist. Die zwei Winkelprofile treten über an ihren Längskanten ausgebildete Nutfederverbindungen miteinander in Eingriff und bilden so einen Zylinder mit einer polygonen (z.B. drei- oder viereckigen) oder runden Grundfläche, dessen Stirnseiten von Stirnwänden abdeckbar sind. Die Stirnseiten müssen gegenüber der Längsachse der Winkelprofile nicht unbedingt senkrecht stehen. Für ein ergonomisch günstig angeordnetes Bedienfeld kann die Stirnwand z.B. in einem Winkel von 45° gegenüber der Längsachse der Winkelprofile geneigt sein.

Ein Gehäuse dieser Art ist günstig herzustellen, weil lediglich ein Strangpreßvorsatz für jedes Profil angeschafft werden muß, welches bei einem Aluminiumwerk eingesetzt wird, und weil außer einer Schneid- und Fräsmaschine keine weiteren großen Investitionen erforderlich sind. Stranggepreßte Profile weisen weniger innere Spannungen und Materialfehler als gebogene Bleche auf, was sich günstig auf die Stabilität eines derartigen Gehäuses auswirkt.

Die Stirnwände können in dem durch die Winkelprofile gebildeten Gehäuse z.B. klappbar oder drehbar aufgehängt bzw. gehalten sein, um einen einfachen Zugriff in das Innere des Gehäuses zu ermöglichen. Festmontierte Stirnwände können z.B. aufgeschraubt sein. Die Stirnwände können dann als ebene Platten ausgebildet sein und vor dem Zusammensetzen der Winkelprofile in die Nut eingesetzt werden. Die Stirnwand kann auch auf einer Seite mit klauenartigen Fortsätzen oder mit als Feder ausgebildeten Abschnitten versehen sein, die in die Nut auf der Innenseite des Gehäuses eingreifen, während die Stirnwand selbst an der Stirnfläche des Gehäuses anliegt. Die Nut verläuft vorzugsweise in einem konstanten Abstand von der Stirnfläche des Gehäuses.

Für die mechanische Stabilität des Gehäuses ist es besonders vorteilhaft, wenn es aus zwei Winkelprofilen besteht, wobei die Längskanten des einen Winkelprofils die Längskanten des anderen Winkelprofils klammerartig umgreifen. Vorzugsweise weist hierfür das eine Winkelprofil an seinen beiden freien Längskanten jeweils ein dem Gehäuseinnern zugewandtes Nut- und/oder Federprofil auf und das andere Winkelprofil weist an seinen freien Längskanten jeweils ein von dem Gehäuseinnern abgewandtes Nut-und/oder Federprofil auf, wobei die Nut- und/oder Federprofile der beiden Winkelprofile im wesentlichen zueinander komplementär sind. Wenn hierbei zumindest ein Schenkel eines Winkelprofils in einem begrenzten Bereich federelastisch ist, können die beiden Winkelprofile aufeinander gelegt und durch leichten Andruck miteinander verbunden werden, wobei die zueinander komplementären Nut-/Federprofile der beiden Winkelprofile ineinander einrasten. Dieser Vorgang wird erleichtert, wenn die Nut-/Federprofile in Richtung der freien Längskanten geneigte Gleitflächen aufweisen, wodurch das Aufeinanderschieben der Winkelprofile unter Auslenkung des federelastischen Schenkels unterstützt wird. Beim Einrasten der Nut-/Federprofile entspannt sich der federelastische Schenkel zumindest weitgehendst. Eine leichte Verspannung der Längskanten der beiden Winkelprofile gegeneinander verbessert den Formschluß der Nut-/Federverbindung und damit die mechanische Stabilität des Gehäuses. Die beiden Winkelprofile dieses Gehäuses sind auch ohne den Einsatz von Stirnwänden mechanisch stabil miteinander verbunden.

Die Investitionskosten für die Fertigung eines Gehäuses können weiterhin verringert werden, wenn die freien Längskanten eines Winkelprofils zueinander komplementäre Rastverbindungen aufweisen und wenn zwei derartige identische Winkelprofile um 180° um ihre Längskante gegeneinander verdreht aneinandergefügt und durch ein an beiden Winkelprofilen angreifendes Verspannelement in dieser Lage festlegbar sind. Es ist dann nur ein Strangpreßvorsatz für jeweils ein Gehäuse erforderlich Die identischen Winkelprofile werden so miteinander verbunden, daß die zueinander komplementären Rastverbindungen ineinandergreifen. Es ist nun möglich, die Rastverbindungen so auszubilden, daß die beiden Winkelprofile in dieser Lage stabil gehalten werden. Vorteilhaft ist jedoch das Anbringen mindestens eines Verspannelementes z.B. an den Stirnseiten, um eine gute mechanische Stabilität des Gehäuses zu gewährleisten. Das Verspannelement verhindert hierbei ein seitliches Auseinanderfallen der beiden Winkelprofile. Das Verspannelement kann gleichzeitig als Stirnwand dienen.

Die oben beschriebenen Gehäuse lassen sich in kleinen Abmessungen bis zu einer Breite von ca. 30 cm, einer Höhe von ca. 20 cm und in beliebigen Längen (Strangpreßverfahren) herstellen. Wirtschaftlich sinnvoll herstellbar sind Gehäusegrößen bis zu einer Höhe von ca. 10 cm und einer Breite von ca. 20 cm. Die Gehäuse eignen sich hervorragend zur Aufnahme von Labormeßgeräten, Stromversorgungen, Stromwandlern etc. Wenn die Winkelprofile und Stirnwände aus Metall, vorzugsweise Aluminium und dessen Legierungen hergestellt sind, wird vor allem durch die ineinandergreifenden Rastverbindungen an den Längskanten eine sehr gute elektrische Abschirmung erreicht.

Das Gehäuse ist auch aus Kunststoff, vorzugsweise metallbeschichtetem Kunststoff, herstellbar, der geeignete mechanische Eigenschaften, wie gute Stabilität und hinreichende Elastizität aufweisen muß. Auch z.B. durch Aufdampfen metallbeschichteter Kunststoff eignet sich gut für ein elektrisch abgeschirmtes Gehäuse.

Vorteilhafte Weiterbildungen der Erfindung sind in den Unteransprüchen beschrieben.

Die Erfindung wird nachfolgend beispielsweise anhand der schematischen Zeichnung beschrieben. Es zeigen:

Fig. 1 eine perspektivische Ansicht eines Gehäuses, bestehend aus zwei Winkelprofilen ohne Stirnwände;

Fig. 2 eine nicht maßstäbliche Aufsicht II auf das Gehäuse aus Fig. 1;

Fig. 3 eine Gehäusehälfte des Gehäuses aus Fig. 2;

Fig. 4 eine Aufsicht IV auf die in Fig. 3 dargestellte Gehäusehälfte;

Fig. 5 eine Stirnwand zum Einsatz in das Gehäuse nach Fig. 2;

Fig. 6 eine Aufsicht auf die Stirnseite eines Gehäuses mit zwei identischen Winkelprofilen;

Fig. 7 ein Winkelprofil des Gehäuses aus Fig. 6;

Fig. 8 eine Aufsicht VIII auf die Innenseite des Winkelprofils aus Fig. 7;

Fig. 9 eine Aufsicht auf ein die Stirnwand bildendes Verspannelement zum Festlegen der Verbindung der beiden Winkelprofile aus Fig. 6 und

Fig. 10 eine Aufsicht X aus Fig. 9.

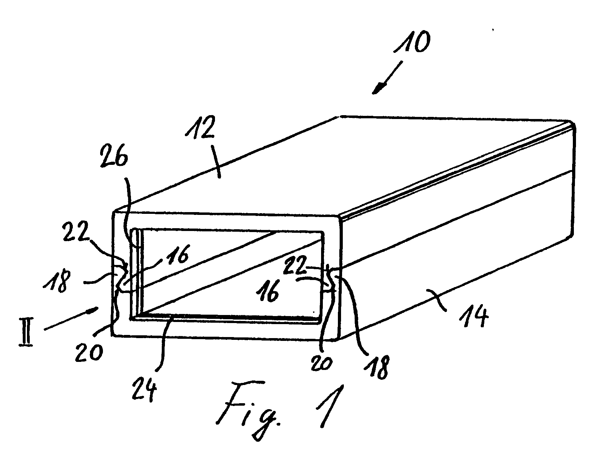

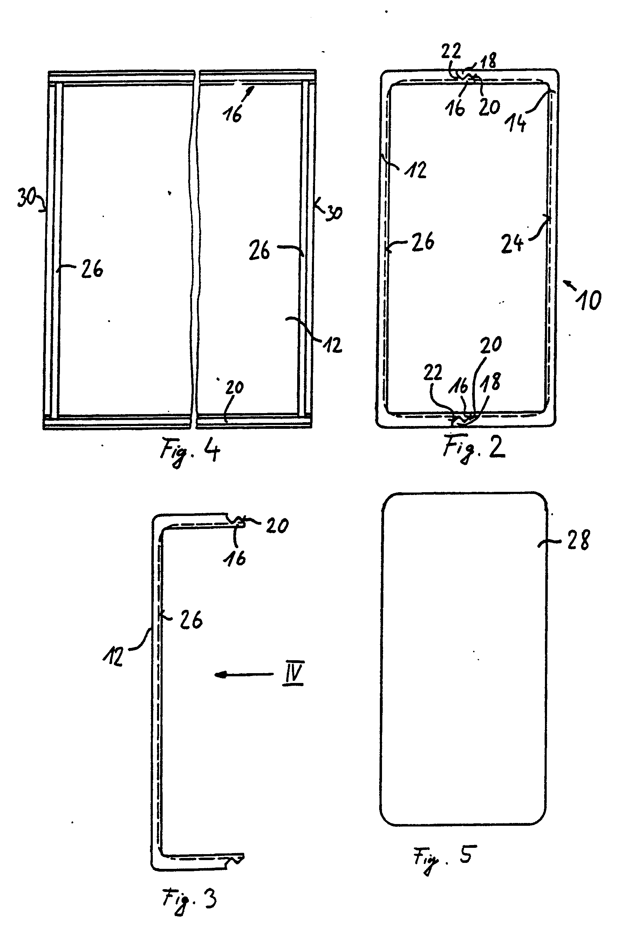

Das Gehäuse 10 besteht, wie in Fig. 1 und 2 dargestellt, aus einem oberen und einem unteren U-förmigen Winkelprofil 12,14, die an ihren freien Längskanten 16,18 über dort ausgebildete Nut-/Federprofile miteinander verbunden sind. Hierfür sind an den freien Längskanten 16 des oberen Winkelprofils 12 voneinander weg und bezüglich des Gehäuses nach außen weisende Nuten und Federn angeordnet, die von an den freien Längskanten 18 des unteren Winkelprofils 14 ausgebildeten aufeinander zu bzw. nach innen weisenden Nut-/Federprofilen klammerartig umgriffen werden.

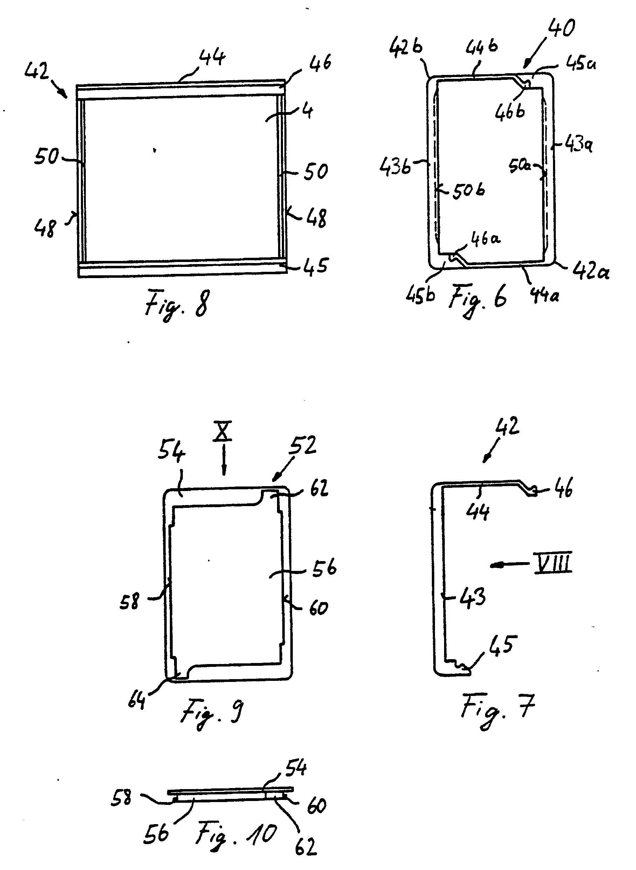

Die Nut-/Federprofile der beiden Winkelprofile 12,14 sind komplementär zueinander ausgebildet. Die beiden Winkelprofile 12,14 werden durch Aufeinanderstecken an den freien Längskanten miteinander verbunden. Hierbei biegen sich die beiden Längskanten 18 des unteren Winkelprofils 14 etwas auseinander, während die freien Längskanten 16 des oberen Winkelprofils 12 ein wenig zusammengedrückt werden. Dies wird dadurch ermöglicht, daß die Winkelprofile 12,14 in einem begrenzten Bereich elastisch verformbar sind. Die an den freien Längskanten 16, 18 der Winkelprofile 12,14 ausgebildeten Federn besitzen zueinander geneigte Gleitflächen 20,22, die ein Zusammendrücken der Winkelprofile 12,14 unter elastischer Verspannung ermöglichen, bis sie sich beim Einrasten in die in den Fig. 1 und 2 dargestellte Verbindungsstellung wieder weitgehend entspannen. Die Winkelprofile 12,14 besitzen an ihren Stirnseiten eine Nut 24,26, in die eine z.B. plane Stirnwand 28 (Fig. 5) vor dem Verbinden der Winkelprofile 12,14 einsetzbar ist. Durch das Einrasten der an den freien Längskanten 16,18 ausgebildeten Nut-/Federverbindungen wird auch die Stirnwand 28 in den Nuten 24,26 festgelegt. In Aufsicht (Fig. 2 und 3) sind die Nuten 24,26 zur Aufnahme der Stirnwand 28 gestrichelt dargestellt.

Fig. 4 zeigt in der Aufsicht IV aus Fig. 3 das Winkelprofil 12 mit den Nuten 26 zur Aufnahme jeweils einer Stirnwand 28 an den Stirnseiten 30 senkrecht zur Längsachse des Winkelprofils 12. Die Nuten 26 für die Aufnahme der Stirnwände 28 verlaufen in einem im wesentlichen konstanten geringen Abstand von den Stirnseiten 30.

Fig. 6 zeigt eine weitere Ausführungsform des Gehäuses 40, bestehend aus zwei identischen L-förmigen Winkelprofilen 42a, b mit zwei senkrecht zueinander verlaufenden Schenkel 43a/b, 44a/b. An den freien Längskanten 45a/b, 46a/b der Winkelprofile 42a/b sind zueinander komplementäre Nut-/Federprofile ausgebildet, die beim Aneinanderfügen der beiden Winkelprofile 42a/b ineinandergreifen.

In Fig. 7 ist eines der beiden identischen Winkelprofile 42 dargestellt, die das Gehäuse 40 aus Fig. 6 bilden.

An den Stirnseiten 48 (Fig. 8) sind Nuten 50 ausgebildet, in die ein Verspannelement 52 (Fig. 9 und 10) einsetzbar ist, um die zwei aneinandergefügten Winkelprofile 42a/b in ihrer Lage relativ zueinander zu fixieren.

In Fig. 9 und 10 ist das Verspannelement 52 dargestellt, das gleichzeitig die Funktion einer Stirnwand ausübt. Das Verspannelement 52 hat einen dünnwandigen Stirnplattenteil 54, der eine Stirnseite 48 des Gehäuses 40 abdeckt. Ein mit dem Stirnplattenteil 54 verbundener dickwandiger Verspannplattenteil 56 hat an zwei einander abgewandten Längsseiten jeweils eine Feder 58, 60, die beim Aufsetzen des Verspannelementes 52 auf das Gehäuse 40 in die an der Stirnseite befindliche Nut 50 eingreift. Der Verspannplattenteil 56 hat an seiner Ober- und Unterseite jeweils einen herausragenden Abstütznocken 62,64, deren Stirnflächen an den Schenkeln 44a/b der zusammengesetzten Winkelprofile 42a/b anliegen und so die ineinander gerastete Lage der beiden Winkelprofile 42a/b relativ zueinander festlegen.

## Ansprüche

1. Gehäuse insbesondere für elektronische Geräte,
dadurch **gekennzeichnet,**
daß mindestens drei uniaxial ausgerichtete Seitenwände des Gehäuses (10,40) durch in Strangpreßverfahren hergestellte Winkelprofile (12,14,42) gebildet sind, die durch im Bereich ihrer freien Längskanten (16,18,45,46) ausgebildete formschlüssige Rastverbindungen, vorzugsweise Nut- und/oder Federprofile miteinander verbunden sind, und daß mindestens eine Stirnseite (30,48) der miteinander verbundenen Winkelprofile (12,14,42) von einer Stirnwand (28,52) abdeckbar ist.

2. Gehäuse nach Anspruch 1,
dadurch **gekennzeichnet,**
daß die Winkelprofile (12,14,42) im Bereich der Stirnseite (30,48) auf ihren einander zugewandten Innenseiten zumindest abschnittsweise eine Nut (26,50) zur Aufnahme einer Stirnwand (28,52) aufweisen.

3. Gehäuse nach Anspruch 1 oder 2,
dadurch **gekennzeichnet,**
daß zwei Winkelprofile (12,14) verwendet werden,
daß das eine Winkelprofil (14) an seinen beiden freien Längskanten (18) jeweils ein dem Gehäuseinnern zugewandtes Nut- und/oder Federprofil aufweist und
daß das andere Winkelprofil (12) an seinen freien Längskanten (16) jeweils ein von dem Gehäuseinnern abgewandtes Nut- und/oder Federprofil aufweist, wobei die Nut- und/oder Federprofile der beiden Winkelprofile (12,14) im wesentlichen zueinander komplementär sind.

4. Gehäuse nach Anspruch 3,
dadurch **gekennzeichne**t,
daß zumindest ein Schenkel eines Winkelprofils (12,14) in einem begrenzten Bereich federelastisch ist.

5. Gehäuse nach Anspruch 1 oder 2,
dadurch **gekennzeichnet,**
daß die freien Längskanten (45,46) eines Winkelprofils (42) zueinander komplementäre Rastverbindungen aufweisen und daß zwei derartige identische Winkelprofile (42a/b) um 180° um ihre Längsachse gegeneinander verdreht aneinandergefügt und durch ein an beiden Winkelprofilen (42a/b) angreifendes Verspannelement (52) in dieser Lage festlegbar sind.

6. Gehäuse nach Anspruch 5,
dadurch **gekennzeichnet,**
daß das Verspannelement (52) als Stirnwand ausgebildet ist.

7. Gehäuse nach einem der vorhergehenden Ansprüche,
dadurch **gekennzeichnet,**
daß die Winkelprofile als L-Profile (42) oder als U-Profile (12,14) ausgebildet sind.

Fig. 1

Fig. 4

Fig. 2

Fig. 3

Fig. 5

Fig. 8

Fig. 6

Fig. 9

Fig. 7

Fig. 10

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | DE-A-3 334 272 (HEILAND) <br> * Seite 2, Absätze 3,6; Figuren 1,2 * <br> --- | 1 | H 05 K 5/00 |
| Y | DE-A-3 420 630 (HEILAND) <br> * Seite 3, Absatz 1; Figuren 1,2 * | 1 | |
| A | . <br> --- | 3,7 | |
| A | US-A-4 023 871 (D. DANTZLER) <br> * Spalte 3, Zeilen 26-40,64-67; Figuren 3-5 * <br> ----- | 1,2,5,7 | |
| | | | **RECHERCHIERTE SACHGEBIETE (Int. Cl.5)** |
| | | | H 05 K 5/00 |

Der vorliegende Recherchenbericht wurde für alle Patentansprüche erstellt

| Recherchenort | Abschlußdatum der Recherche | Prüfer |
|---|---|---|
| BERLIN | 18-04-1990 | ALEXATOS G |

EPO FORM 1503 03.82 (P0403)

**KATEGORIE DER GENANNTEN DOKUMENTE**

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument